# EUROPÄISCHE PATENTANMELDUNG

(11) **EP 2 584 661 A2**
(43) Veröffentlichungstag der Anmeldung: **24.04.2013**
(21) Anmeldenummer: 12007255.8
(22) Anmeldetag: 22.10.2012
(51) Int. Cl.: H01S 3/0941, H01S 5/40, H01S 3/14

(54) **Verteilte Energieversorgung eines Laserwaffensystems**

(30) Priorität: 21.10.2011 DE 102011116570; 17.01.2012 DE 102012000672
(71) Anmelder: MBDA Deutschland GmbH, 86529 Schrobenhausen (DE)
(72) Erfinder: Hagen, Thomas, 85296 Rohrbach/Ilm (DE)
(74) Vertreter: Avenhaus, Beate

(57) **Zusammenfassung**

Die Erfindung betrifft einen Aufbau zur Energieversorgung eines Laserwaffensystems auf der Grundlage von mit elektrischer Energie betriebenen diodengepumpten Lasern (10). Hierbei ist der Aufbau so gestaltet, dass die Betriebseigenschaften der zum optischen Pumpen verwendeten Vielzahl von Halbleiterlaserelementen ("Laserdioden"; 601 ... 650) unter den beim typischen Betrieb eines Laserwaffensystems auftretenden Randbedingungen bezüglich Stromaufnahme und Spannungsaufnahme in optimaler Weise an eine elektrische Primärenergieversorgung angepasst werden, und nachteilige Effekte wie hohe elektrische Verluste, unerwünschte elektromagnetische Störabstrahlungen und magnetische Kräfte so weit als möglich vermieden, sowie weiter die Betriebszuverlässigkeit so weit als möglich gesteigert wird

## Beschreibung

### Stand der Technik

Der Stand der Technik im Bereich der Laserquellen sowie der zugehörigen Optik lässt es möglich erscheinen, Wirksysteme gegen unterschiedliche Klassen von Zielen - zum Selbstschutz von Plattformen oder für den offensiven Einsatz - auf der Grundlage von Hochenergie-Lasern zu realisieren. Hierzu gehören Anwendungen gegen statische Ziele wie Minen, IEDs (Improvised Explosive Devices, behelfsmäßige Spreng- und Brandvorrichtungen), Sperren, aber auch gegen dynamische Ziele, speziell im Rahmen der Abwehr der Bedrohung durch fliegende Objekte wie RAM (Rocket, Artillery, Mortar), Lenkflugkörper mit und ohne Suchkopf, Drohnen / UAVs (Unmanned Aerial Vehicle; unbemannte Luftfahrzeuge), etc.

Es ist dabei weiter Stand der Technik, dass zur wirksamen Bekämpfung solcher Ziele optische Strahlungsleistungen zu erzeugen sind, die in den Bereich deutlich oberhalb von 100 Kilowatt (kW), z.B. 250 kW reichen. Hierbei liegt es in der Natur einer Bedrohung, dass diese in der Regel ohne Vorwarnung auftreten, und es erforderlich ist, diese in Zeiträumen von Bruchteilen von Sekunden bis zu einigen wenigen Sekunden zu bekämpfen. Da dabei auch der Fall auftreten kann, dass mehrere Ziele gleichzeitig zu bekämpfen sind, ist mit Gesamtzeiträumen zur Niederschlagung eines Angriffs im Bereich von einigen Sekunden (s) bis einigen 10 s (z.B. 60 s) zu rechnen, während der ein Laserwaffensystem kontinuierlich einsatzbereit sein muss.

Unabhängig von der Art der Ausführung des eigentlichen laseraktiven Mediums (als Stab-, Slab-, Faser- oder Scheibenlaser) eines solchen Systems handelt es sich bei solchen System dem Stand der Technik entsprechend heutzutage durchgehend um so genannte diodengepumpte Laser (meist Festkörperlaser, es sind aber auch Flüssigkeits-, Gas- oder Metalldampflaser nach diesem Prinzip bekannt), d.h. die Umwandlung der primären Energie in Form elektrischer Energie in Strahlungsenergie zur optischen Anregung des laseraktiven Mediums findet durch eine (große) Anzahl von Halbleiterlasern ("Diodenlaser") statt.

Hierbei liegt der Wirkungsgrad für die Umwandlung elektrischer Energie in Strahlungsenergie zur optischen Anregung einerseits und für die Umwandlung dieser Strahlungsenergie zur optischen Anregung in die optische Ausgangsleistung des Lasersystems andererseits bereits aufgrund physikalischer Gesetzmäßigkeiten deutlich unter eins. In der Praxis werden für beide Vorgänge dem Stand der Technik entsprechend jeweils Wirkungsgrade von ca. 50 % erreicht, so dass der häufig als Steckdosenwirkungsgrad bezeichnete Gesamtwirkungsgrad der Umwandlung elektrischer Energie in Strahlungsenergie des Lasers im Bereich von 25 % liegt. Hierzu kommen noch optische Verluste bei der Übertragung der Strahlungsenergie, sowie elektrische Verluste in Leitungen sowie in üblicherweise zur kontrollierten Steuerung der Halbleiterlaser sowie zur Energiewandlung angewandten elektronischen Schaltungen.

In jedem Fall ist zum Betrieb eines solchen Systems bei einer realistisch anzunehmenden notwendigen optischen Strahlungsausgangsleistung von 250 kW und einem Gesamtwirkungsgrad von unter 25 % mindestens eine einzusetzende elektrische Leistung von über 1000 kW erforderlich, welche von einer elektrischen Energieversorgung bereitgestellt werden muss.

Bei industriellen Anwendungen von elektrisch betriebenen Lasern erfolgt die Energieversorgung in der Regel aus einem öffentlichen Stromnetz, wobei weiter zu berücksichtigen ist, dass die im industriellen Einsatz betriebenen Lasern eine optische Ausgangsleistung von nur wenigen kW besitzen, und weiter weitgehend im kontinuierlichen Betrieb (24 h / 7 d) eingesetzt werden.

Ein solcher Betrieb ist im militärischen Einsatz als Waffensystem nicht möglich, da eine geeignete, fest installierte elektrische Energieversorgung in der Regel nicht vorhanden ist. Die Versorgung mit elektrischer Primärenergie erfolgt bei mobilen oder transportablen Systemen üblicherweise über motorisch (Verbrennungsmotor, Gasturbine) angetriebene elektrodynamische Generatoren, in neuerer Zeit auch durch elektrochemische Generatoren ("Brennstoffzellen").

Unglücklicherweise verträgt sich das aus dem Einsatzprofil eines Laserwaffensystems (stand-by über nahezu die gesamte Lebensdauer, hochfahren auf volle Leistung in Bruchteilen von Sekunden, anschließend Betrieb in Volllast über wenige Sekunden, abschließend herunterfahren in kurzer Zeit in ein erneutes stand-by) ergebende elektrische Lastprofil nur sehr schlecht mit dem möglichen Lastprofil der o.g. elektrischen Primärenergieversorgungen, die auf solchen Betrieb mit Abbremsung bis zum Stillstand oder gar Zerstörung reagieren.

Andererseits verbietet es sich schon aus Gründen des sich ergebenden Primärenergieverbrauchs, der damit verbundenen Kosten, und auch aus Gründen des Verschleißes, einen Generatorsatz genannter Leistung über längere Zeiträume bei voller Leistung sozusagen in Bereitschaft zu halten, um die notwendige elektrische Leistung jederzeit und unmittelbar zur Verfügung zu haben.

Aus diesem Grund wird bei den genannten Laserwaffensystemen eine Vorrichtung zur Pufferung elektrischer Energie vorzusehen sein, welche die Lastprofile des Lasersystems und der elektrischen Primärenergieversorgung in geeigneter Weise aufeinander anpasst.

Dem Stand der Technik entsprechend kann eine kurzfristige und entsprechend leistungsfähige Speicherung elektrischer Energie dabei grundsätzlich z.B. mittels Schwungradspeichern, elektrochemischen Akkumulatoren oder auch hochkapazitiven Kondensatoren ("Supercaps") erfolgen.

Sowohl elektrochemische Akkumulatoren als auch hochkapazitive Kondensatoren ("Supercaps") zeichnen sich dabei dadurch aus, dass das verfügbare (Entladen) bzw. benötigte (Laden) Spannungsniveau je Einzelelement im Bereich von einigen wenigen Volt liegt. Li-Polymer- oder Li-lonen-Akkumulatoren verfügen beispielsweise über eine Ladeschlussspannung von 3,7 Volt bzw. 3,3 Volt (V). Die Betriebsspannung von hochkapazitiven Kondensatoren wird durch die Durchbruchspannung der Isolationsschicht bestimmt, die bei den benötigten Kapazitäten von vielen Farad regelmäßig ebenfalls deutlich unter 10 V liegt.

Weiter liegt die gespeicherte Energie je Einzelelement im Bereich von einigen wenigen Wattstunden (Wh) bis zu einigen 100 Wh. Die für einen Betrieb eines Systems mit einem elektrischen Leistungsbedarf von z.B. 1000 kW über eine typische Einschaltdauer von 60 s zu speichernde elektrische Energie von in diesem Fall 60 Megajoule wird also auf eine größere Anzahl von zur Speicherung verwendeten Einzelelementen aufzuteilen sein, so dass sich der benötigte nutzbare Gesamtenergieinhalt ergibt. In der Praxis wird sich dabei eine Anzahl von wenigen hundert bis einigen tausend erforderlichen Einzelelementen ergeben.

Wie bereits erwähnt, erfolgt die Umwandlung elektrischer Energie in die für die Anregung des laseraktiven Mediums benötigte optische Strahlungsenergie in für den Einsatz in Laserwaffensystemen vorgesehene Laserquellen durch Halbleiterlaser.

Betrachtet man solche Halbleiterlaser näher, so liegt natürlich der Wunsch auf der Hand, deren Anzahl insgesamt so klein als möglich zu halten, also eine möglichst hohe Leistung je Einzelelement verfügbar zu haben. Diesem Wunsch sind aber durch die Notwendigkeit zur Abfuhr der entstehenden Verlustwärme und die technologischen Möglichkeiten der Herstellung Grenzen gesetzt.

Verfügbare Halbleiterlaser im für die optische Anregung des Lasermediums eines Laserwaffensystems notwendigen Wellenlängenbereich besitzen eine optische Ausgangsleistung je Einzelelement von wenigen Watt (W) bis einigen 10 W, in Ausnahmefällen auch 100 W. Die für ein Laserwaffensystem erforderliche optische Anregungsleistung von 500 kW und mehr kann also nur durch die gleichzeitige Verwendung sehr vieler (5000 bis 50000) solcher Einzelelemente zur Verfügung gestellt werden.

Weiter haben die verfügbaren Halbleiterlaser die Eigenschaft, dass die Betriebsspannung eines Einzelelementes durch die Durchflussspannung der Diode bestimmt wird, welche für typische Halbleiterlaser im Bereich von ca. 2 V liegt, was bei einer optische Ausgangsleistung je Einzelelement von z.B. 100 W und einem elektrischoptischen Wirkungsgrad von 50 % einen Betriebsstrom von bereits ca. 100 Ampere (A) bedingt. Ein typischer Betriebsstrom in dieser Größenordnung wird technisch auch dadurch bedingt, dass solche Halbleiterlaser aus physikalischen Gründen einen Mindestansprechstrom (Schwellenstrom) benötigen, da erst oberhalb dessen eine Laseremission einsetzt.

Aus praktischen Gründen wird daher in der Regel eine Reihe von Einzelelementen sowohl optisch/mechanisch direkt gekoppelt, als auch elektrisch in Serie geschaltet.

Die mögliche Erhöhung der Betriebsspannung findet dabei allerdings in der Realisierung der notwendigen elektrischen Isolierung eine Grenze, und auch darin, dass insbesondere in mobilen Systemen ein Spannungsniveau oberhalb des Kleinspannungsbereiches von einigen 10 V (typische zulässige Grenzspannungen liegen im Bereich von 42 V bis 120 V Gleichspannung) wegen der sich dann ergebenden erhöhten elektrischen Schutzanforderungen in der Regel unerwünscht ist.

Ein typisches, auch im industriellen Bereich übliches Spannungsniveau für den Betrieb von zum Pumpen von Lasern genutzten Anordnungen mehrerer Laserdioden liegt im Bereich von 16 V bis 60 V, in Einzelfällen auch geringfügig darunter oder darüber.

Weiter ergibt sich durch die Serienschaltung der Effekt, dass Ausfälle von Einzelelementen, mit denen immer zur rechnen ist, dann eine Störung von einer sehr viel größeren Anzahl von Elementen bewirken, und im Extremfall zum katastrophalen Versagen des Gesamtsystems führen.

Bei einem globalen Stromniveau von 16000 A wird dann weiter ein Gesamtleitungsquerschnitt von über 30 Quadratzentimeter benötigt, wenn der elektrische Leistungsverlust bei einer angenommenen Leitungslänge von 10 m unterhalb von 3 % gehalten werden soll. Bei solchen Leitungsquerschnitten ist natürlich an flexible Kabel oder gar die Nutzung von Steckverbindungen zur Trennung nicht mehr zu denken. Auch treten bei solchen Strömen magnetische Störfelder erheblicher Stärke auf, die bereits an sich und auch durch die von ihnen hervorgerufenen mechanischen Kräfte unerwünscht und technisch schwer zu beherrschen sind.

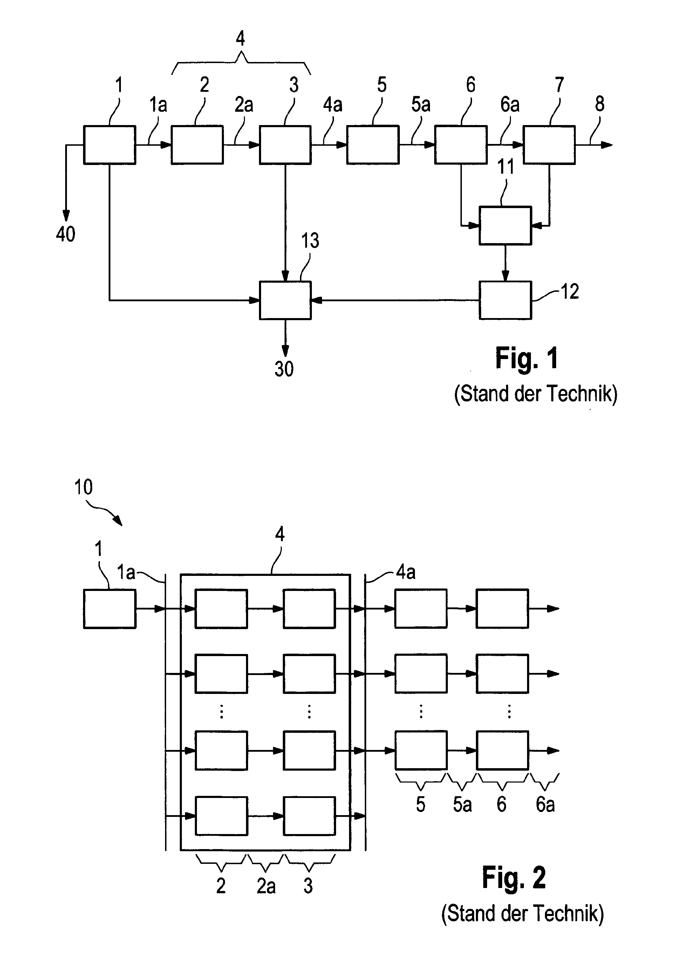

Der gesamte Energiefluss in einem Laserwaffensystem ist exemplarisch anhand der genannten Kenndaten und für ein Puls-Pausen-Verhältnis (Betrieb zu stand-by) von 60 Sekunden zu 15 Minuten in Figur 1 dargestellt.

Wie in Figur 1 gezeigt ist, ist ausgehend von einer elektrischen Primärenergieversorgung 1 zunächst ein aus Ladeelektronik 2 und entsprechendem Speicherelement 3 aufgebauter elektrischer Energiespeicher 4 mit dem benötigten Energieinhalt vorhanden, welcher die zur Aufladung benötigte Energie der genannten elektrischen Primärenergieversorgung 1 entnimmt. Daneben kann die Primärenergieversorgung 1 weitere Verbraucher 40 versorgen. Die Ladeelektronik 2 ist über die Leitung 1 a mit der Primärenergiequelle 1 und über die Verbindung 2a mit dem Speicherelement 3 verbunden.

Als Beispiel hat die Primärenergieversorgung eine Ausgangsleistung von 100 kW bzw. 125 kVA. Davon werden maximal 75 kW über die Leitung 1a an die Ladeelektronik 2 abgegeben. Das Energiespeicherelement 3 weist eine gesamte Kapazität von 60 MJ auf und wird von der Ladelektronik 2 mit 60 kW 15 Minuten lang geladen.

Im weiteren speist, wie aus Figur 1 ersichtlich, der elektrische Energiespeicher 4 während des eigentlichen Betriebs des Laserwaffensystems 10 die zum Betrieb des zum optischen Pumpen vorgesehenen Halbleiterlasers 6 notwendige Diodenstromquelle 5, wobei zwischen dem Energiespeicher 4 und den genannten Diodenstromquelle 5 mindestens an einer Stelle, nämlich in der Leitung 4a, ein Stromniveau der genannten kritischen Größe von mehreren 1000 A auftritt.

Dem obigen Beispiel folgend wird der Energiespeicher 4 in 60 Sekunden entladen, so dass durch die Leitung 4a eine elektrische Leistung von 1000 kW an die Diodenstromquellen übertragen wird. Bei einer typischen Spannung von 60 V fließt daher ein Strom von 16 kA. Die Diodenstromquelle gibt diese Leistung über die Verbindung 5a an den Halbleiterlaser 6 ab. Der Halbleiterlaser 6 gibt die aufgenommene Leistung mit einem Wirkungsgrad von 50 % als optische Strahlungsleistung 6a an das laseraktive Medium 7 ab. Die dadurch verursachte Anregung des Mediums erzeugt schließlich den Laserstrahl 8, wobei der Wirkungsgrad wiederum 50 % beträgt. Daher weist der Laserstrahl 8 eine optische Leistung von 250 kW auf.

Auf Grund von den auftretenden Verlusten in Form von Wärmeentwicklung müssen die Primärenergieversorgung 1, die Speicherelemente 3, die Halbleiterlaser 6 und das laseraktive Medium 7 gekühlt werden. Dies geschieht über die Wärmepumpe 13, wobei die Halbleiterlaser 6 und das laseraktive Medium 7 über eine zusätzliche Kühlung 11 inklusive Wärmepuffer 12 verfügen, welche dafür sorgen, das Temperaturniveau in dem für den Betrieb erforderlichen engen Bereich zu halten. Die Wärmepumpe 13 gibt die Wärme von Primärenergieversorgung 1, Halbleiterlaser 6 und Wärmepuffer 12 an die Umgebung 30 ab.

Weiter wird bei der genannten Lösung in der Regel eine räumliche Trennung zwischen dem elektrischen Energiespeicher 4 einerseits und den dem optisch anzuregenden laseraktiven Medium 7 räumlich zugeordneten Pumpdioden 6 andererseits gewählt werden bzw. vorliegen. Dies vergrößert jedoch den Übertragungsweg der Leitung 4a, in dem der hohe Strom von mehreren 1000 A auftritt.

Ausgehend von dem zuvor gesagten ergibt sich damit dem Stand der Technik entsprechend und mit den beschriebenen Nachteilen behaftet ein Gesamtaufbau für eine elektrische Energieversorgung eines Laserwaffensystems wie in Figur 2 dargestellt. Hierbei werden die gleichen Daten verwendet wie im Beispiel aus Figur 1.

Es ist ersichtlich, dass die Ladeelektronik 2, das Speicherelement 3 und die Verbindung 2a durch eine Vielzahl an einzelnen Bauteilen umgesetzt werden. Aus diesen Bauteilen wird der Energiespeicher 4 gebildet, der über die Leitung 1 a von einer Primärenergieversorgung 1 gespeist wird (z.B. mit 75 kW). Ebenso wird die Diodenstromquelle 5 und der Halbleiterlaser 6 durch eine Vielzahl an einzelnen Bauteilen umgesetzt. Dennoch bleibt eine Leitung 4a bestehen, durch die die gesamte Leistung vom Energiespeicher 4 zu den einzelnen Elementen der Diodenstromquelle 5 übertragen wird (z.B. 1000 kW, 60V, 16kA). Von der Diodenstromquelle wird die Leistung über die einzelnen Leitungen der Verbindung 5a zu den jeweiligen Elementen des Halbleiterlasers 6 übertragen, so dass sich der hohe Strom aus der Leitung 4a in eine Vielzahl an kleineren Strömen aufteilt. Jedes Element des Halbleiterlasers gibt eine bestimmte optische Leistung ab, die sich auf die optische Leistung 6a (500 kW) summiert und die auf das laseraktive Medium (in Figur 2 nicht dargestellt) übertragen wird.

Es ist Aufgabe der Erfindung, ein Lasersystem bereitzustellen, das die oben genannten Nachteile beseitigt, also insbesondere robuster gegen einzelne Ausfälle ist und mit geringeren Stromstärken arbeitet.

### Offenbarung der Erfindung

Die Aufgabe wird gelöst durch die Merkmale der Ansprüche 1 und 6. Es wird eine Vorrichtung zum Emmitieren eines Laserstrahls offenbart, die eine Vielzahl von Baugruppen zur Übertragung von optischer Strahlungsenergie auf das laseraktive Medium umfasst, wobei jede Baugruppe eigenständig betriebsfähig ist. Jede Baugruppe besteht aus einer Energiespeichervorrichtung zur Pufferung, einer Steuervorrichtung für die Energiespeichervorrichtung ("Ladeelektronik"), einer Halbleiterlaservorrichtung, einer Steuervorrichtung für die Halbleiterlaservorrichtung (elektrische Energiekonditionierung) und einem laseraktiven Medium. Die Halbleiterlaservorrichtung umfasst mindestens ein Halbleiterlaserelement ("Pumpelement"). An die Ladeelektronik kann eine Primärenergieversorgung angeschlossen werden, um den Energiespeicher nach Gebrauch vollständig aufzuladen und anschließend aufgeladen zu halten.

Eine solche Baugruppe hat den Vorteil, dass die sie ausmachenden einzelnen Vorrichtungen zueinander in enger räumlicher Nähe angeordnet werden und diese Vorrichtungen - eine entsprechende Steuerung von außen vorausgesetzt - jeweils eigenständig betriebsfähig sind. Es ergibt sich eine erhöhte Zuverlässigkeit und Einsatzbereitschaft des Gesamtsystems, da sich durch den redundanten Aufbau ein Ausfall einer einzelnen Baugruppe nicht auf die Funktionalität des Gesamtsystems niederschlägt.

Weiter zeichnet sich die erfindungsgemäße Lösung dadurch aus, dass das Produkt aus Stromniveau und Leitungslänge insgesamt minimiert wird. Hierdurch kann einerseits die Abstrahlung magnetischer Störfelder sowie das Auftreten elektromagnetischer Kräfte extrem verringert werden. Andererseits ermöglicht die räumlich enge Anordnung der betroffenen Komponenten sowohl eine einfachere Kapselung gegen elektromagnetische Störeinflüsse als auch einen mechanisch robusten Aufbau.

Alternativ kann anstatt der Energiespeichervorrichtung eine elektrochemische Energiewandelvorrichtung, insbesondere eine Brennstoffzelle verwendet werden, welche chemische Energie in elektrische Energie umwandelt und dadurch in der Lage ist, eine elektrische Leistung abzugeben. Dadurch wird der Aufbau des Lasersystems sehr vereinfacht, die Energiewandelvorrichtung muss jedoch eine ausreichende Leistungsfähigkeit aufweisen, um dem oben beschriebenen Lastprofil des Lasersystems gerecht zu werden. Dazu muss auch eine entsprechende Zuführung und Abführung von benötigten Medien zu bzw. von den Energiewandelvorrichtungen jeder Baugruppe des Lasersystems gewährleistet sein.

Die Unteransprüche haben bevorzugte Weiterbildungen der Erfindung zum Inhalt.

In einer bevorzugten Ausführungsform umfasst die Energiespeichervorrichtung elektrochemische Speicher, insbesondere Akkumulatoren. Diese Akkumulatoren sind bevorzugt auf Lithium-Polymer Basis oder auf Lithium-lonen Basis gefertigt. Alternativ umfasst die Energiespeichervorrichtung kapazitive Speicher, insbesondere Kondensatoren. Hier ist es vorteilhaft hochkapazitive Dünnschicht-Kondensatoren ("Supercaps"), zu verwenden.

Sowohl elektrochemische Akkumulatoren als auch hochkapazitive Kondensatoren zeichnen sich dabei dadurch aus, dass das verfügbare (Entladen) bzw. benötigte (Laden) Spannungsniveau je Einzelelement im Bereich von einigen wenigen Volt liegt. Akkus auf Lithium-Polymer oder Lithium-lonen Basis verfügen beispielsweise über eine Ladeschlussspannung von 3,7 Volt bzw. 3,3 Volt. Die Betriebsspannung von hochkapazitiven Kondensatoren wird durch die Durchbruchspannung der Isolationsschicht bestimmt, die bei den benötigten Kapazitäten von mehreren Farad regelmäßig ebenfalls deutlich unter 10 Volt liegt. Daher lassen sich aus mehreren Kondensatoren, Akkumulatoren oder einer Kombination aus beidem Energiespeicher fertigen, die eine gewünschte Spannung aufweisen.

Weiterhin kann in vorteilhafter Weise die Primärenergie zum Nachladen der genannten Energiespeicher über motorisch, beispielsweise über einen Verbrennungsmotor oder eine Gasturbine, angetriebene elektrodynamische Generatoren, alternativ auch durch elektrochemische Generatoren ("Brennstoffzellen") erfolgen. Damit wird sichergestellt, dass der Energiespeicher stets geladen wird, das Lasersystem somit in einem Bereitschaftszustand gehalten wird.

Bevorzugt wird die Steuervorrichtung für die Halbleiterlaservorrichtung ("Energiekonditionierung" bzw. "Diodenstromquelle") und die Steuervorrichtung für die Energiespeichervorrichtung ("Ladeelektronik") in einer gemeinsamen Steuervorrichtung zusammengefasst. Auf diese Weise können wesentliche Schaltungsaufgaben, z.B. Steuerung und Regelung, gemeinsam ausgeführt werden.

In einer bevorzugten Ausgestaltung der Erfindung überschreitet eine elektrische Spannung innerhalb einer Baugruppe 200 Volt nicht. Weiter bevorzugt bleibt die Spannung insbesondere kleiner oder gleich 120 Volt. Ebenso bevorzugt überschreitet ein elektrischer Strom innerhalb einer Baugruppe 1000 Ampere nicht. Insbesondere ist der Strom innerhalb einer Baugruppe nicht größer als 500 Ampere. Beispielsweise tritt in jeder Baugruppe ein Strom- und Spannungsniveau auf der Entladeseite von einigen 10 V und wenigen 100 A, auf der Ladeseite ein um das Puls-Pausen-Verhältnis (Betrieb zu stand-by) reduziertes Stromniveau von einigen Ampere bis wenigen 10 A auf.

Solche elektrischen Kenndaten sind sowohl isolationstechnisch, als auch von den benötigten Leitungsquerschnitten, elektrischen Verbindungen (auch lösbare elektrische Steckverbindungen sind einsetzbar) und elektronischen Steuerelementen sehr gut beherrschbar.

Außerdem ist es vorteilhaft, wenn das laseraktive Medium einen Festkörper umfasst, wobei insbesondere ein Stablaser oder ein Slablaser oder ein Faserlaser oder ein Scheibenlaser verwendet wird. Einzelne dieser Geometrien können auch kombiniert werden. Alternativ umfasst das laseraktive Medium ein Fluid, wobei insbesondere ein Flüssigkeitslaser oder ein Gaslaser oder ein Metalldampflaser verwendet wird. Auch hier ist eine Kombination von verschiedenen Lasertypen möglich. Diese Medien können einfach mit optischen Halbleiterlaserelementen gepumpt werden.

### Kurze Beschreibung der Zeichnungen

Weitere Einzelheiten, Merkmale und Vorteile der Erfindung ergeben sich aus nachfolgender Beschreibung von Ausführungsbeispielen anhand der Zeichnungen. Darin zeigt:
- Figur 1:: eine Übersicht über den globalen Energiefluss eines Lasersystems gemäß dem Stand der Technik
- Figur 2:: die Energieversorgung eines Lasersystems gemäß dem Stand der Technik
- Figur 3:: die Energieversorgung eines Lasersystems gemäß einer Ausführungsform der Erfindung

Gleiche Bezugzeichen beziehen sich durchgehend auf gleiche oder ähnliche Elemente in den Zeichnungen.

### Beschreibung der bevorzugten Ausführungsform(en) der Erfindung

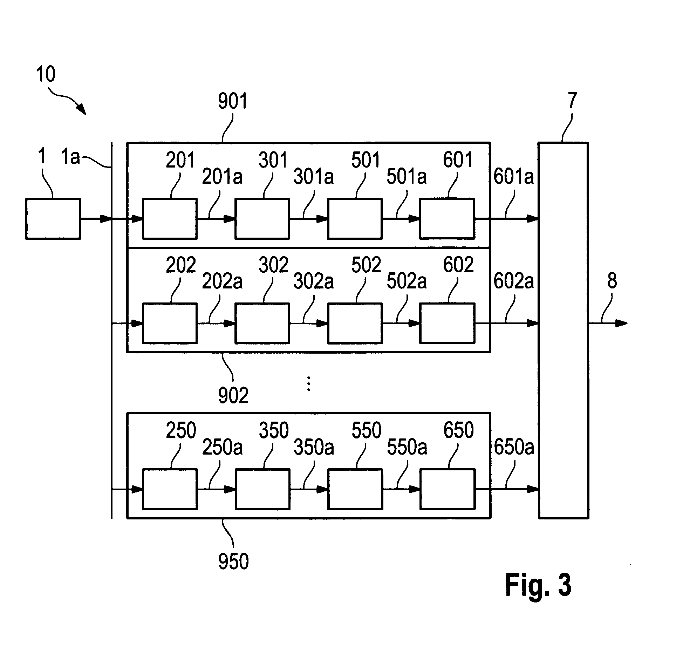

Figur 3 zeigt ein Ausführungsbeispiel eines erfindungsgemäßen Lasersystems 10 mit fünfzig Baugruppen 901; 902; ...; 950. Es wird eine Brennstoffzelle 1 verwendet, welche eine elektrische Leistung von 60 kW erzeugt, die an die Baugruppen 901; 902; ...; 950 abgegeben wird. Jede Baugruppe umfasst eine Ladeelektronik 201; 202; ...; 250, einen Energiespeicher 301; 302; ...; 350, eine Diodenstromquelle 501; 502; ...; 550 und Laserdioden 601; 602; ...; 650.

Die Ladeelektroniken 201; 202; ...; 250 sind an eine Leitung 1 a angeschlossen, über die die Brennstoffzelle 1 die von ihr erzeugte elektrische Leistung abgibt. Sie leiten jeweils die erzeugte elektrische Leistung über eine jeweilige Leitung 201a; 202a; ...; 250a in die Energiespeicher 301; 301a; ...; 350 ein. Die Energiespeicher 301; 302; ...; 350 haben ein jeweiliges Speichervermögen von 1200 kJ, was einem gesamten Speichervermögen von 50 x 1200 kJ = 60 MJ entspricht. Daher dauert es 60 MJ / 60 kW = 1000 Sekunden, also knapp 17 Minuten bis alle Energiespeicher 301; 302; ...; 350 voll geladen sind.

Zum Speichern der Energie verwendet jede Energiespeichervorrichtung 301; 302; ...; 350 eine passende Anzahl an Kondensatoren, so dass sich eine gesamte Eingangsspannung bzw. Ausgangsspannung jedes Energiespeichers von 60 V ergibt. Dies kann beispielsweise durch eine Parallelschaltung von sechs Kondensatoren geschehen, die auf eine Spannung von jeweils 10 V aufgeladen werden.

Im Betrieb des Lasers 8 beziehen die einzelnen Diodenstromquellen 501; 502; ...; 550 über eine jeweilige Leitung 301a; 302a; ...; 350a die elektrische Leistung aus den Energiespeichern 301; 302; ...; 350 und leiten diese über die jeweilige Leitung 501 a; 502a; ...; 550a an die Laserdioden 601; 602; ...; 650 weiter. Dabei werden die Energiespeicher 301; 302; ...; 350 innerhalb von einer Minute entladen, so dass sich eine gesamte Ausgangsleistung von 60 MJ / 60 s = 1000 kW ergibt, also 20 kW pro Leitung 301 a; 302a; ...; 350a. Folglich ergibt sich nur ein Strom von 20 kW / 60 V = 333 A zwischen Energiespeicher 301; 302; ...; 350 und Diodenstromquelle 501; 502; ...; 550 pro Bauteil 901; 902; ...; 950. Dies ist der höchste Strom, der in dem gesamten Lasersystem 10 auftritt.

Mit der elektrischen Leistung aus den Leitungen 501a; 502a; ...; 550a werden schließlich die Laserdioden 601; 602; ...; 650 versorgt, wobei in jeder Baugruppe 901; 902; ...; 950 eine bestimmte Anzahl an Laserdioden 601; 602; ...; 650 in Reihenschaltung und in Parallelschaltung angeordnet ist. Die Laserdioden 601; 602; ...; 650 weisen einen Wirkungsgrad von 50% auf, so dass von den 20 kW, die von jeder Energiespeichervorrichtung 301; 302; ...; 350 abgegeben werden, lediglich 10 kW pro Baugruppe 901; 902; ...; 950 als optische Strahlungsleistung 601 a; 602a; ...; 650a an das laseraktiven Mediums 7 für die optische Anregung abgegeben werden, insgesamt also 50 x 10 kW = 500 kW.

Das laseraktive Medium 7 weist wiederum einen Wirkungsgrad von 50% auf, so dass der ausgesandte Laserstrahl 8 eine optische Ausgangsleistung von 250 kW aufweist. Dieser Laserstrahl kann nun zur Abwehr von Bedrohungen, beispielsweise von Raketen, verwendet werden.

Auch wenn die vorstehenden Erläuterungen anhand der beigefügten Zeichnungsfiguren ausführlich und detailliert beschrieben worden sind, bleibt der Bereich der vorliegenden Erfindung allein durch die beiliegenden Schutzansprüche definiert. Der Kerngedanke der Erfindung betrifft demnach einen Aufbau zur Energieversorgung eines Laserwaffensystems auf der Grundlage von mit elektrischer Energie betriebenen diodengepumpten Lasern. Hierbei ist der Aufbau so gestaltet, dass die Betriebseigenschaften der zum optischen Pumpen verwendeten Vielzahl von Halbleiterlaserelementen ("Laserdioden") unter den beim typischen Betrieb eines Laserwaffensystems auftretenden Randbedingungen bezüglich Stromaufnahme und Spannungsaufnahme in optimaler Weise an eine elektrische Primärenergieversorgung angepasst werden, und nachteilige Effekte wie hohe elektrische Verluste, unerwünschte elektromagnetische Störabstrahlungen und magnetische Kräfte so weit als möglich vermieden, sowie weiter die Betriebszuverlässigkeit so weit als möglich gesteigert wird

## Patentansprüche

1. Vorrichtung (10) zum Emmitieren eines Laserstrahls (8), umfassend
- eine Energiespeichervorrichtung (301; 302; ...; 350) zum Speichern von Energie, wobei die Energiespeichervorrichtung (301; 302; ...; 350) eingerichtet ist, über eine Leitung (301 a; 302a; ...; 350a) elektrische Leistung auszugeben,
- eine Steuervorrichtung (201; 202; ...; 250) für die Energiespeichervorrichtung (301; 302; ...; 350), welche über eine Leitung (201 a; 202a; ...; 250a) eine zu speichernde Energiemenge in die Energiespeichervorrichtung (301; 302; ...; 350) einleitet,
- ein laseraktives Medium (7), welches eine optische Strahlungsleistung (601 a; 602a; ...; 650a) in eine optische Leistung des Laserstrahls (8) wandelt,
- eine Halbleiterlaservorrichtung (601; 602; ...; 650), welche das laseraktive Medium (7) optisch anregt, indem eine elektrische Leistung in die optische Strahlungsleistung (601 a; 602a; ...; 650a) gewandelt wird, und
- eine Steuervorrichtung (501; 502; ...; 550) für die Halbleiterlaservorrichtung (601; 602; ...; 650), welche der Halbleiterlaservorrichtung (601; 602; ...; 650) über eine Leitung (501 a; 502a; ...; 550a) die elektrische Leistung aus der Energiespeichervorrichtung (301; 302; ...; 350) bereitstellt, **gekennzeichnet dadurch, dass**
- sämtliche Vorrichtungen (201, 301, 501, 601; 202, 302, 502, 602; ...; 250, 350, 550, 650) in einer Baugruppe (901; 902; ...; 950) zusammengefasst sind, und
- eine Vielzahl von derartigen Baugruppen (901; 902; ...; 950) zur Übertragung von optischer Strahlungsleistung (601 a; 602a; ...; 650a) auf das laseraktive Medium (7) verwendet werden, wobei jede Baugruppe (901; 902; ...; 950) eigenständig betriebsfähig ist.

2. Vorrichtung nach Anspruch 1, **dadurch gekennzeichnet, dass** die Energiespeichervorrichtung (301; 302; ...; 350) elektrochemische Speicher, insbesondere Akkumulatoren, insbesondere Akkumulatoren auf Lithium-Polymer-Basis und/oder auf Lithium-lonen-Basis, umfasst.

3. Vorrichtung nach Anspruch 1, **dadurch gekennzeichnet, dass** die Energiespeichervorrichtung (301; 302; ...; 350) kapazitive Speicher, insbesondere Kondensatoren, insbesondere hochkapazitive Dünnschicht-Kondensatoren, umfasst.

4. Vorrichtung nach einem der vorherigen Ansprüche, **dadurch gekennzeichnet, dass** die Energiemenge, die über eine Leitung (1a) an die Steuervorrichtung (201; 202; ...; 250) für die Energiespeichervorrichtung (301; 302; ...; 350) abgegeben wird, von einem zusätzlichen Energiewandler (1) insbesondere elektrodynamisch, insbesondere durch einen an einen Verbrennungsmotor und/oder eine Gasturbine angeschlossenen Generator, und/oder elektrochemisch, insbesondere durch eine Brennstoffzelle, erzeugt wird.

5. Vorrichtung nach einem der vorherigen Ansprüche, **dadurch gekennzeichnet, dass** die Steuervorrichtung (501; 502; ...; 550) für die Halbleiterlaservorrichtung (601; 602; ...; 650) und die Steuervorrichtung (201; 202; ...; 250) für die Energiespeichervorrichtung (301; 302; ...; 350) in einer gemeinsamen Steuervorrichtung zusammengefasst sind.

6. Vorrichtung (10) zum Emmitieren eines Laserstrahls (8), umfassend
- eine elektrochemische Energiewandelvorrichtung (1), insbesondere eine Brennstoffzelle, welche chemische Energie in elektrische Energie umwandelt und dadurch in der Lage ist, eine elektrische Leistung abzugeben,
- ein laseraktives Medium (7), welches eine optische Strahlungsleistung (601 a; 602a; ...; 650a) in eine optische Leistung des Laserstrahls (8) wandelt,
- eine Halbleiterlaservorrichtung (601; 602; ...; 650), welche das laseraktive Medium (7) optisch anregt, indem die elektrische Leistung in die optische Strahlungsleistung (601 a; 602a; ...; 650a) gewandelt wird, und
- eine Steuervorrichtung (501; 502; ...; 550) für die Halbleiterlaservorrichtung (601; 602; ...; 650), welche der Halbleiterlaservorrichtung (601; 602; ...; 650) über eine Leitung (501 a; 502a; ...; 550a) die elektrische Leistung aus der Energiewandelvorrichtung (1) bereitstellt,
**gekennzeichnet dadurch, dass**
- sämtliche Vorrichtungen (1; 501, 601; 502, 602; ...; 550, 650) in einer Baugruppe (901; 902; ...; 950) zusammengefasst sind, und
- eine Vielzahl von derartigen Baugruppen (901; 902; ...; 950) zur Übertragung von optischer Strahlungsleistung (601 a; 602a; ...; 650a) auf das laseraktive Medium (7) verwendet werden, wobei jede Baugruppe (901; 902; ...; 950) eigenständig betriebsfähig ist.

7. Vorrichtung nach einem der vorherigen Ansprüche, **dadurch gekennzeichnet, dass** eine elektrische Spannung innerhalb einer Baugruppe (901; 902; ...; 950) 200 Volt, insbesondere 120 Volt nicht überschreitet.

8. Vorrichtung nach einem der vorhergehenden Ansprüche, **dadurch gekennzeichnet, dass** ein elektrischer Strom innerhalb einer Baugruppe (901; 902; ...; 950) 1000 Ampere nicht überschreitet, insbesondere 500 Ampere nicht überschreitet.

9. Vorrichtung nach einem der vorherigen Ansprüche, **dadurch gekennzeichnet, dass** das laseraktive Medium (7) einen Festkörper umfasst, wobei insbesondere ein Stablaser und/oder ein Slablaser und/oder ein Faserlaser und/oder ein Scheibenlaser verwendet wird.

10. Vorrichtung nach einem der vorherigen Ansprüche, **dadurch gekennzeichnet, dass** das laseraktive Medium (7) ein Fluid umfasst, wobei insbesondere ein Flüssigkeitslaser und/oder ein Gaslaser und/oder ein Metalldampflaser verwendet wird.
